# EUROPEAN PATENT SPECIFICATION

(11) **EP 0 988 556 B1**
(45) Date of publication and mention of the grant of the patent: **19.02.2003**
(21) Application number: 98928444.3
(22) Date of filing: 10.06.1998
(51) Int. Cl.: G01R 1/00

(54) **IMPROVEMENTS IN, OR RELATING TO, ELECTRICITY CONSUMPTION METERS**
VERBESSERUNGEN AN ODER IN BEZUG AUF ELEKTRIZITÄTSZÄHLER
AMELIORATIONS CONCERNANT LES COMPTEURS D'ELECTRICITE

(30) Priority: 11.06.1997 GB 9712180; 12.02.1998 GB 9803028
(43) Date of publication of application: 29.03.2000
(73) Proprietor: ABB Metering Limited, Luton, Bedfordshire LU1 3LJ (GB)
(72) Inventor: JONES, Alan, John, Newcastle ST5 2BA (GB); MITCHELL, Nicholas, Andrew, Staffordshire ST16 1TW (GB); SHINGLER, Adrian, Thomas, Stone Staffordshire ST11 9LT (GB); SHEPHERD, Harold, Sigley, Stafford Staffordshire ST18 0JW (GB); MASKERY, Jeffrey, Stoke-on-Trent Staffordshire ST11 9JT (GB); WADE, Paul, Stoke-on-Trent Staffordshire ST4 8DY (GB)
(74) Representative: Moir, Michael Christopher
(86) International application number: GB9801693
(87) International publication number: WO98057184

(56) References cited:
- EP-A- 0 717 286
- US-A- 3 878 391
- US-A- 5 089 771
- US-A- 5 296 803

## Description

This invention relates to electricity consumption meters and more especially to the construction of an electro-mechanical electricity consumption meter.

Electro-mechanical electricity consumption meters are well known and have been in widespread use for many years. Typically such meters log the total number of units of electricity consumed since the installation of the meter. This consumption information is stored mechanically using barrel registers or dial registers which can be read through a window in the meter housing.

With the ever decreasing cost of electronic circuitry a trend has developed towards electronic electricity meters which include microprocessors and are thus capable of performing a number of functions in addition to logging the total number of units of electricity consumed. For example, electronic electricity meters are known which are capable of operating using multi-tariffs, keeping a record of the time of use for the various tariffs or remotely communicating with the electricity supplier to name but a few.

The inventors have appreciated that whilst such electronic electricity consumption meters provide flexible metering of electricity consumption they do have limitations. A major drawback of electronic meters is their short operating life which is typically no longer than 10 years. This is due primarily to three factors: (i) the liquid crystal display often used in these meters has a life expectancy of 10 years; (ii) the battery used in the battery backed memory has an operating life of 10 years; and (iii) electrolytic capacitors typically last 10 to 15 years. In contrast, electro-mechanical electricity consumption meters have been used in continuous service for 50 years and require only minimal refurbishment every 25 years or so. A further limitation of both electronic and electro-mechanical electricity meters alike is meeting diverse and changing electricity metering needs.

An example of these changing metering needs is that with the deregulation of the electricity companies in the United Kingdom, new market opportunities will arise for the supply of electricity to both industrial and domestic consumers alike. The regional electricity companies (RECs) who currently supply electricity in the UK purchase electricity from a pooling arrangement in which the various electricity generating companies, eg. Nuclear Electric, Power Gen etc, place tenders to supply electricity to the pool in which the electricity is traded and priced on a half hourly basis. Settlement of an REC's purchase occurs at the end of a one month period. Following deregulation in 1998 this system will be extended so that industrial and domestic consumers will be able to select from which REC they purchase electricity, irrespective of their geographic location in relation to the selected REC and irrespective of which REC owns the cabling connecting the customer to the electricity network. To enable the REC to settle payment for supplying energy to a consumer situated in the territory of another REC it will be necessary to log, every half hour, the number of units of electricity supplied for each customer over a one month period. As a consequence a new electricity consumption meter will be required.

Designing electricity consumption meters is costly as they must meet stringent regulations laid down by the appropriate authorities and must be approved by those authorities before they can be installed in the market. A need exists therefore for a meter which is flexible in its operation and which can accommodate future market needs without the need to replace the meter.

To meet the uncertainties of single phase electricity metering, a modular electronic electricity meter has been proposed which comprises a basic meter to which add-on modules can be attached. The basic meter can measure consumption of electricity and keep a running total of the number of units of electricity used. The basic meter also includes an optical communications port which allows the attachment of an add-on module which is capable of providing an ancillary function to the basic metering function such as, for example, a prepayment function or multi-tariff function or remote reading function etc. Whilst such an arrangement provides a flexible metering system the meter still suffers the problem of a short service life as compared to an electro-mechanical meter.

It has been estimated that there are currently in excess of 23 million domestic consumer electricity consumption meters in operation in the UK. Of these, the majority - in excess of 20 million - are Ferraris-type electro-mechanical meters having an operating life of 50 years. Nearly all of these meters are capable of recording only the total number of units of electricity consumed.

In an attempt to avoid the need to replace these meters it has been proposed to provide an optical pickup assembly which is attached to the window of the meter to detect rotation of the Ferraris disc and thereby determine the rate of consumption of electricity. One such apparatus is described in EP 0717286 which comprises a casing which is fitted over and substantially encloses the meter's sealed housing and which contains an optical pickup for detecting rotation of the disc through the meter's window. This however undesirably enlarges the overall size of the meter, and presents difficulities in reading the meter visually because the display must be viewed through two thicknesses of window.

The inventors have appreciated that a need exists therefore for an electricity consumption meter having the reliability of an electro-mechanical electricity meter and having the flexibility of an electronic meter to accommodate future metering needs, whilst remaining compact and easy to read visually. This is achieved by at least the preferred embodiment of the invention.

According to the present invention there is provided an electro-mechanical electricity consumption meter of a type having a sealed housing to prevent tampering therewith, the sealed housing having a transparent region permitting visibility of a consumption indicator, connecting terminals for connecting the meter to an electricity supply and to a load, and a rotor assembly whose rate of rotation is related to the rate of consumption of electricity: characterised by a part of the rotor assembly or a component adapted to rotate with the rotor assembly having at least one marking thereon such that the rate of rotation of the rotor assembly can be determined using an optical monitoring assembly, and by removable sealable cover structure disposed over a portion of the sealed housing other than the said transparent region, which structure in conjunction with the sealed housing provides a volume in which the optical monitoring assembly can be housed externally of and relative to the sealed housing so as to view the part or component through the sealed housing from under the cover structure.

Preferably said part of the rotor assembly or said component is located in close proximity to said connecting terminals.

By providing at least one marking on a part of the rotor assembly or on a component adapted to rotate with the rotor and which is in close proximity to the connecting terminals, this enables an optical assembly and associated electronic circuitry to be readily attached to the me ter without requiring access to the interior of the meter's sealed housing and without the need to break the integrity of the sealed housing. Maintaining the integrity of the sealed housing is important as the meter has to be 'certified' and the housing sealed at the time of manufacture having satisfied stringent class accuracy requirements. Since the meter of the present invention does not include any form of electronic components inside its sealed housing, it has a long operating life expectancy, yet is still able to meet future metering needs.

In a particularly preferred embodiment the rotating component comprises a part of a magnetic suspension arrangement of the rotor assembly which is adapted to have the, or each, marking on a surface thereof.

Preferably the sealable structure comprises at least one sealable terminal cover for preventing access to one or more of said terminals.

Again preferably the sealable cover structure comprises a first cover which prevents access to supply connecting terminals and a second cover providing said volume in conjunction with the sealed housing.

By adapting the sealable cover structure as a terminal cover this provides a secure. housing for the optical monitoring assembly and any associated electronic circuitry cover which is in close proximity to the rotating component and the connecting terminals. Most preferably separate sealable terminal covers are provided for the supply and load connecting terminals and the optical monitoring assembly and associated electronic circuitry are preferably accessible by removal of the load connecting terminal cover. A particular advantage of such an arrangement is that since a larger number of people are authorised to have access to the load connecting terminals, and hence remove this cover, this enables a larger number of persons to fit the optical assembly/circuitry. In contrast access to the supply connecting terminals is usually restricted to persons authorised by the electricity supplier in order to reduce fraudulent use of electricity by bypassing the meter. Preferably the meter further includes means to prevent an operator accidentally touching or otherwise accessing the connecting terminals when the sealable terminal cover is removed.

Preferably the at least one marking comprises a visually distinctive boundary between two surfaces of substantially different reflectivity such as for example one or more stripes. Advantageously these areas comprise a metallic surface, such as metallic chromium, and a material of relatively lower reflectivity, such as for example a plastics material. Such an arrangement ensures that the difference in optical reflectivity between the stripe and unmarked surface remains high and is resistant to tarnishing or other degradation over many years of operation.

When a part of the magnetic suspension arrangement is used it is particularly preferred if the meter further comprises a clip which fits over a part of the magnet suspension arrangement and includes regions which mask the surface of the magnetic suspension arrangement to define the at least one marking. Preferably the clip is made from stainless steel or from nickel plated brass to ensure the reflectivity of the markings do not degrade appreciably over many years of operation and to prevent the clip from magnetically interfering with the operation of the suspension arrangement.

To ensure the optical assembly can reliably detect rotation of the magnetic suspension arrangement the sealed housing is advantageously adapted to include a recessed region to enable an optical monitoring assembly to be located in close proximity to the magnetic suspension arrangement, said recessed region further including barrier means, preferably in the form of one, or more, ribs extending into the recessed region, for preventing a magnet being placed in close proximity to the magnetic suspension arrangement or the disc of the rotor assembly.

Advantageously the meter further comprises means, preferably a light guide, for directing light from under the sealable cover structure to the transparent region of the meter's sealed housing which is visible when the terminal cover is in place. Such an arrangement makes it possible to communicate with the electronic circuitry associated with the optical assembly without the need to remove the terminal cover or to gain access to the inside of the sealed housing. Such a light guide can be located on an inner or outer surface of the sealed housing and is advantageously formed as an integral part of the sealed housing when the sealed housing is made from a transparent material. When the sealed housing is made from a transparent material it is advantageous if the meter further comprises masking means arranged to prevent light reaching the optical monitoring assembly which has originated from outside of the meter.

Preferably the meter is further adapted such that an isolating switch is connectable to the connecting terminals, the isolating switch being located externally of the sealed housing and enclosed by the sealable cover structure. Sinoe the isolating switch is located externally of the sealed housing it can be fitted after the installation of the meter should it be required or be replaced should it fail without compromising the meter's sealed housing. The isolating switch can be used for a number of purposes such as for example as an installer switch which enables the meter installer, currently the regional electricity company (REC), to isolate the electricity supply without having to remove the main fuse which is connected in the electricity supply line. Since the main fuse has to be sealed by the REC, a second site visit would otherwise be necessary once all wiring to the load connecting terminals was complete, were the installer switch not present. In alternative arrangements the isolating switch can be used for different purposes such as for example to enable the meter to act as a prepayment meter and prevent further supply of electricity when a consumer's credit is absent.

In a preferred form of the meter the isolating switch is connectable to the load connecting terminals and the load connecting terminals include at least one removable link to enable the isolating switch to be connected when the at least one link is removed, said at least one link being accessible by removal of the sealable terminal cover.

According to a further aspect of the invention there is provided a module for use with an electricity consumption meter as described above, said module being configured to provide an ancillary function to the metering of electricity usage, comprises an optical monitoring assembly for detecting rotation of the rotating component and electrical circuitry, said module being adapted to be located outside the sealed housing of the meter and is enclosed by the sealable cover structure.

An electricity consumption meter in accordance with the various aspects of the present invention will be described by way of example only with reference to the accompanying drawings in which:
Figure 1 is a front view of an electricity consumption meter in accordance with the invention;
Figure 2 is a side view of the meter of Figure 1;
Figure 3 is a schematic representation of the rotor assembly of the meter of Figures 1 and 2;
Figures 4a and 4b are perspective views of a preferred rotor assembly of the meter of Figures 1 and 2 (a) as an exploded view and (b) in an assembled form;
Figures 5a and 5b are perspective views of the meter of Figure 1 with the terminal cover (a) removed and (b) fitted;
Figure 6 is a cut-away schematic of part of a meter in accordance with the invention including an electronic module; and
Figure 7 is a cut-away schematic of the terminal region of a meter in accordance with the invention.

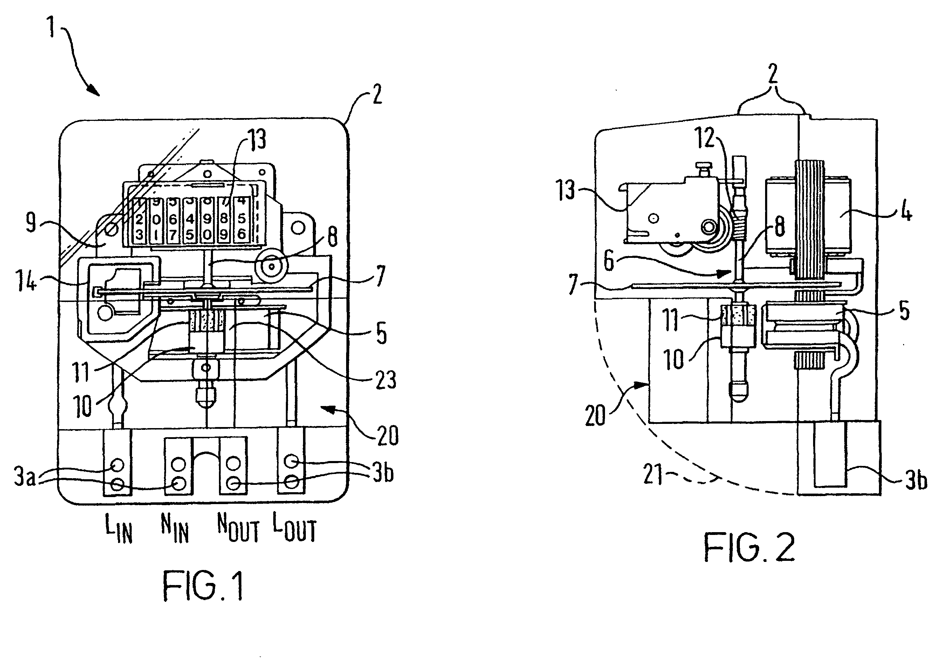

Referring to Figures 1 and 2 there is shown an electro-mechanical electricity consumption meter 1 of a known type often termed a Ferraris meter. The meter 1 comprises a sealed housing 2 which includes electrical connecting terminal pairs 3a, 3b for respective connection to an electricity supply and to a consumer load, voltage 4 and current 5 sensing electromagnets, and a rotor assembly 6 which comprises a disc 7 (often termed a Ferraris disc) mounted on a spindle 8. The voltage and current sensing electromagnets 4, 5, are fixed to a frame 9 and are arranged to induce eddy currents into the disc 7 such that the rate of rotation of the disc 7 is proportional to the rate of consumption of electrical power between the terminal pairs 3a, 3b.

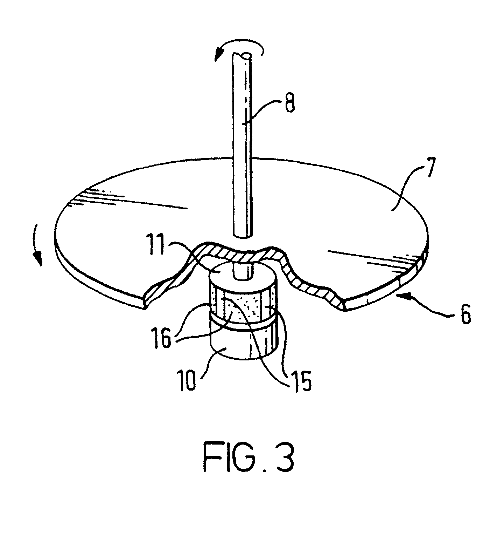

As shown in Figure 3, the rotor assembly 6 is rotatably supported at its lower end by a magnetic suspension arrangement which comprises respective magnets 10 and 11. The upper magnet 11 is rotatable and is coupled to the spindle 8. The lower magnet 10 is fixed to the frame 9 and is arranged such as to repel the rotatable magnet 11 thereby enabling substantially frictionless rotation of the rotor assembly 6.

Referring again to Figures 1 and 2, rotation of the rotor assembly 6 is coupled by a worm drive 12 to a mechanical barrel register 13 which is mounted on the frame 9. The barrel register 13 keeps a record of the total number of units of electricity consumed since the installation of the meter, and is visible through the sealed housing 2 which is made of a transparent material. As is also known the meter 1 includes a brake magnet 14 which ensures that the rate of rotation of the disc 7 is directly proportional to the rate of electricity consumption.

So far the meter 1 described is of a known type. Unlike the known meters the rotatable magnet 11 of the magnetic suspension arrangement has visually distinctive markings 15 provided on its surface as shown in Figure 3. The markings 15 are such as to permit rotation of the magnet 11 to be detected optically.

The markings 15 comprise three stripes 15 which are disposed in a direction which is transverse to the direction of movement of the surface of the magnet 11. The stripes 15 are arranged at equally spaced intervals around the circumference of the magnet 11 and comprise a high reflectivity material such as for example metallic chromium. The surface 16 of the magnet 11 between the stripes 15 comprises a surface whose reflectivity is substantially different to those of the stripes such as, for example, a low reflectivity plastics material.

The magnet 11 thus provides a rotatable component having discrete regions of different optical reflectivity. The use of chromium and a plastics material ensures that this difference in reflectivity will remain high as both materials are resistant to degradation over many years of operation.

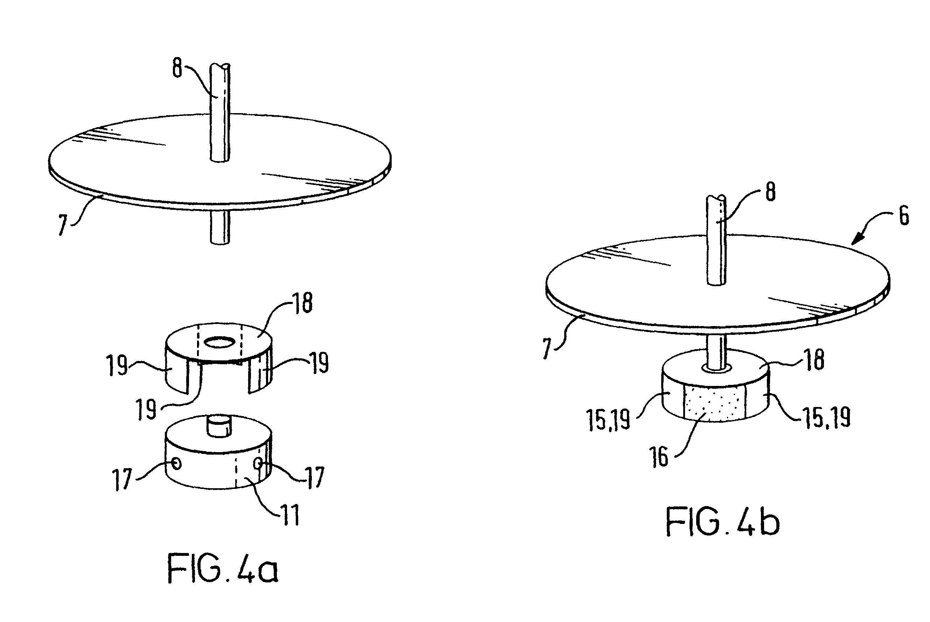

Referring to Figures 4a and 4b there is shown a perspective view of a particularly preferred form of rotor assembly 6 in accordance with the invention. The rotatable magnet 11 is made from a sintered material and has three indents 17 spaced equidistant around the curved surface of the magnet. A clip 18, attached to the end of the spindle 8 of the rotor assembly, is arranged to fit over the outer surface of the magnet 11. The clip 18, which is preferably made from stainless steel, nickel plated brass or any other non-magnetic corrosion resistant reflective material, has three arms 19 which extend in an axial direction and include protrusions on their inner surface (not shown) which, when fitted to the magnet, co-operate with the indents 17 to hold the magnet 11 to the clip 18. The arms 19, which have a highly reflective surface, provide the highly reflective markings 15 and the surfaces of the magnet which are not masked by the clip provide the relatively less reflecting regions 16. A particular advantage of this arrangement is that the clip provides a dual function of providing the visually distinctive markings 15 and fixing the magnet 11 securely to the rotor assembly 6.

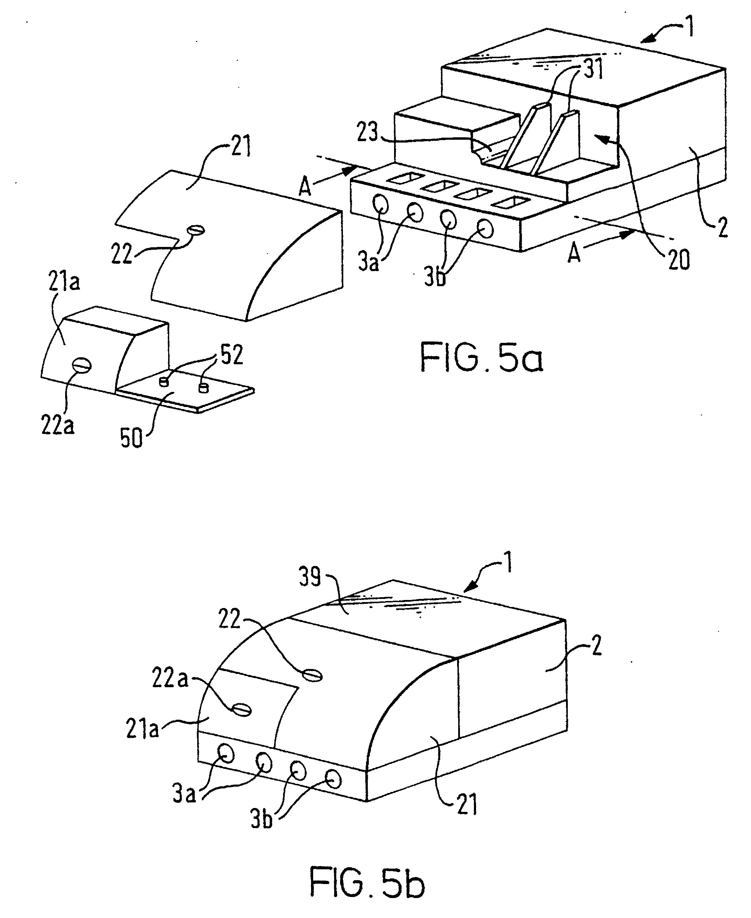

Referring to Figures 5a and 5b there is shown a perspective view of the meter 1. The sealed housing 2 is modified in the region of the magnetic suspension arrangement to form a recessed region 20. It should be noted that the recessed region 20 is formed as an integral part of the sealed housing 2 and does not allow access to the interior of the meter 1. The integrity of the sealed housing 2 is thus not compromised in any way. A two part removable terminal cover 21, 21a is provided to prevent unauthorised access to the terminals 3a, 3b and is fixed to the meter using respective sealable screw fixtures 22, 22a.

The first part of the terminal cover 21a is shaped such that, when fitted, it prevents access to the supply connecting terminals 3a. This terminal cover is fitted and sealed when the meter is installed, typically by the Regional Electricity Company (REC). The first part of the terminal cover 21a includes a plate 50 which extends over the load terminals 3b to prevent an operator accidentally touching or otherwise accessing these terminals when the second part of the terminal cover 21 is removed. The second part of the terminal cover 21 is shaped to enclose the recessed region 20 and to form a volume in which electronic circuitry can be securely housed.

In the recessed region 20 a window 23 is formed from the wall of the sealed housing 2 to allow optical access to the rotating magnet 11 which is located inside the housing 2. In the embodiment illustrated the sealed housing is made from a transparent plastics material and the window 23 is curved such as to generally follow the outer surface of the magnet 11.

In operation, when the meter 1 is required to perform a metering function other than keeping a record of the total number of units consumed, the terminal cover 21 is removed by removing of the screw fixture 22. An electronic module (not shown), which is capable of performing a function ancillary to the basic metering such as for example a multi tariff function or prepayment function, or is capable of allowing the meter to be read remotely, is then mounted in the recessed region 20.

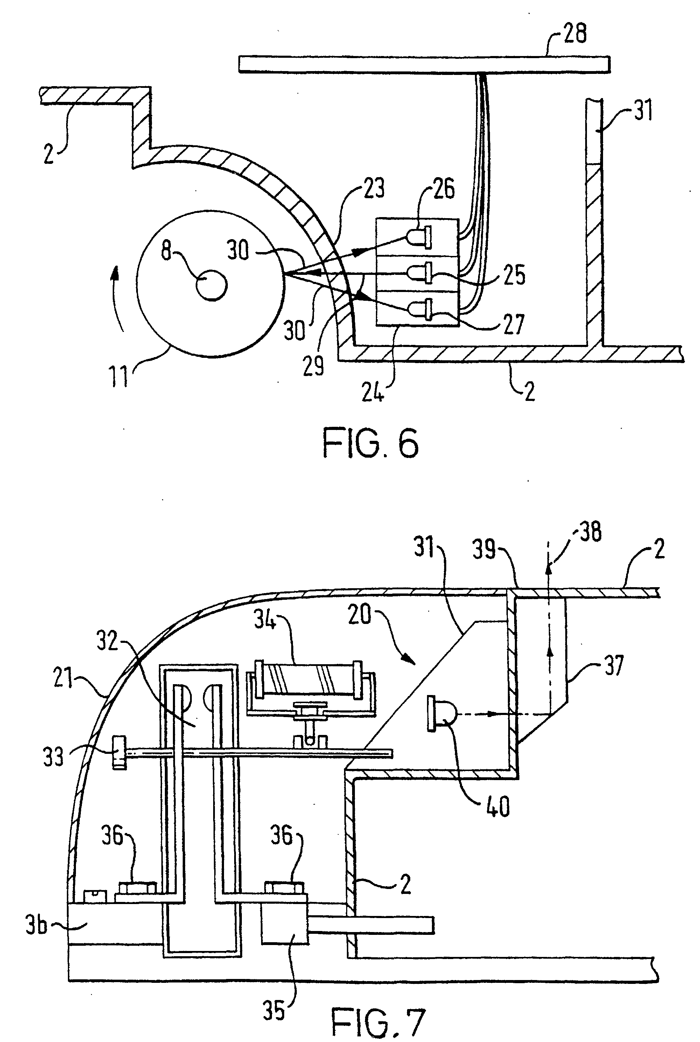

Referring to Figure 6 there is shown a cut-away schematic of the meter as viewed from the terminals. The electronic circuit module includes an optical monitoring assembly 24 which comprises a light emitting diode (LED) 25 and two photo-transistors 26, 27 and electronic circuitry 28. The LED 22 is arranged to direct light 29 through the window 23 onto the surface of the magnet 11. Light 30 which is reflected from the magnet 11 is detected through the window 23 by the photo-transistors 26 and 27. The intensity of the reflected light 30 is modulated by the marking 15 as the magnet 11 rotates. The optical monitoring assembly 24 is thus capable of measuring the rotation of the magnet 11 through the window 23 by utilising the relative movement of the markings 15 past the assembly 24.

Electrical power for the electronic circuitry 28 is derived from the electrical terminal pair 3b which include sockets which are accessible through corresponding apertures 52 in the plate 50. To prevent an operator accidentally touching or otherwise accessing these terminals when the cover 21 is removed the apertures 52 are shielded by appropriate shaping of the plate 50. Once the electronic module has been mounted to the meter the terminal cover 21 is replaced to securely enclose the module and to prevent tamper therewith. Since the rate of rotation of the magnet 11 is related to the rate of consumption of electricity the electronic module can determine the rate of consumption of electricity and hence the number of units of electricity consumed subsequent to its installation.

It will be appreciated by those skilled in the art that by appropriate design of the electronic circuitry 28 any required function ancillary to the logging of the number units of electricity consumed can be readily provided.

The meter of the present invention can thus be adapted to provide any ancillary function through the provision of a rotating component, the magnet 11 in the embodiment shown, whose rate of rotation is related to the rate of consumption of the commodity. A particular advantage of the invention is that the electronic module can be fitted to the meter without requiring access to the interior of the meter. It is particularly important that the housing 2 is not damaged or compromised in any way as this would invalidate the certification status of the meter. Any damage to the housing 2 would require the meter to be resealed and recertified which would require it being taken out of service.

It will be appreciated that the recessed portion 20 provides two functions. Firstly, it provides the window 23 for optical access to the rotatable magnet 11. Secondly, in conjunction with a modified electrical terminal cover 21, it defines a volume in which the electronic module can be securely housed with a reduced likelihood of unauthorised interference.

A particular advantage of detecting rotation of a part of the magnetic suspension arrangement is its close proximity to the meter's electrical terminals 3b which are used to provide electrical power to the electronic module. It is particularly preferred to have a two part terminal cover as this enables electronic modules to be fitted to the meter without requiring access to the supply terminals 3a. Preventing access to the supply terminals 3a stops the meter being bypassed and other forms of tamper. It will be appreciated that attempts to defraud the meter using the output terminals 3b will still be registered. As a result, a wider range of persons may be authorised to remove the cover 21 and fit electronic modules to the meter. Hitherto only authorised persons from the Regional Electricity Companies (RECs) were allowed to remove the terminal cover of the known meters.

As described the recessed portion 20 ensures that the window 23 is in close proximity to the magnetic suspension arrangement. Whilst this arrangement ensures reliable optical access it does however make it possible for someone to defraud the meter by placing a magnet in close proximity to the magnetic suspension arrangement or the underside of the disc 7 to slow, or even stop, rotation of the rotor assembly 6. To prevent this type of fraud the sealed housing 2 further includes one or more fins 31 in the recessed region 20. The fins 31 are dimensioned and spaced such that they act as a physical barrier to prevent a magnet being placed in close enough proximity to the magnetic suspension arrangement to affect its operation. The electronic circuitry 28 of the electronic module includes corresponding slots enabling the circuitry to be fitted around the fins 31.

Furthermore, since the sealed housing is made from a transparent material, this further opens up the possibility of someone attempting to saturate the optical assembly using light sources external to the meter 1. To prevent this form of tamper the meter includes a mask (not shown) which can be formed as an integral part of the sealed housing or fitted to the exterior of the housing within the recessed region. The mask, which is opaque to light or substantially so, includes an aperture to define the window 23 and is arranged to mask a substantial portion of the recessed region 20 located under the terminal cover 21.

Referring to Figure 7, there is shown a cut-away schematic of the terminal region of the 5 meter in accordance with the invention. In this embodiment the output terminals 3b are adapted such that an isolating switch 32 is connectable to them. The isolating switch 32, when actuated, prevents electrical power passing through the meter to the output terminals 3b. The isolating switch 32 is located in the recessed region 20 and housed under the terminal cover 21. Since the switch 32 is located externally of the sealed housing, it can be fitted subsequent to the installation of the meter and can be replaced, should it fail, without requiring access to the interior of the meter.

The switch 32 can be actuated manually using an actuating button 33 which is accessible by removal of the terminal cover 21. This arrangement enables the meter installer, currently the regional electricity company (REC), to isolate outgoing supply without having to remove the main fuse which is located on the incoming terminal. Since the main fuse has to be sealed by the REC, a second site visit would otherwise be necessary once all wiring to the load connecting terminals was complete, were the switch not present. Alternatively the isolating switch can be operated using a solenoid 34 which can be controlled by the electronic circuitry 28. In such an arrangement it will be appreciated that the meter 1 can thus be adapted to function as a prepayment meter and prevent further supply of electricity when a consumer's credit is absent.

In the preferred embodiment illustrated, the meter can be supplied with or without the isolating switch 32 already connected. In the latter case, a removable link (not shown) is connected between the output terminal 3b and a conductor 35. To connect the isolating switch 32, the terminal cover 21 is removed and the link is removed by taking out the bolts 36. The isolating switch 32 is then connected in the electrical path between the conductor 35 and output terminals 3b. The concept of adapting an electro-mechanical electricity meter such that an isolating switch is connectable to the connecting terminals and is located externally of the sealed housing and enclosed by the terminal cover is considered inventive in itself.

To enable the electronic circuitry 28 to communicate with external equipment, a light guide 37 is provided on the inside of the sealed housing 2. The light guide is arranged to direct light 38 from under the terminal cover 21, through a window 39 in the front of the housing 2. The electronic circuitry 28 further includes an optical source/detector 40, enabling the circuitry 28 to communicate with the external equipment. For example, the light guide can be utilised to remotely read the meter using a hand-held interrogator or to program the electronic circuitry 28 with tariff information. In the embodiment illustrated, the light guide 37 is formed as an integral part of the sealed housing 2, which is made from a transparent plastics material. In other embodiments the guide could be formed integrally on the outer surface or as a separate component on either surface. Since the function of the light guide 37 is to direct light 38 from under the terminal cover to a window 39 in the meter's housing, other forms of light guiding means can be used such as, for example, an arrangement of mirrors. It will be appreciated that adapting the meter such that light can be guided in this way provides further flexibility in the meter's operation without the inclusion of any electrical or electronic components within the meter which might reduce its operating life. Adapting an electro-mechanical electricity meter in this way is also considered inventive in its own right.

It will be appreciated by those skilled in the art that modifications to the meter described can be made which are within the scope of the various aspects of the present invention. Thus, whilst in the embodiment described the magnet 11 has three stripes arranged equidistant around its circumference, it is also envisaged to use one, or more, visually distinct marks on the component surface. For example, a plurality of stripes can be applied whose spacing, and/or whose width, is selected to provide a coded signal. Furthermore it will be appreciated that the stripes need not be aligned with the axis of rotation of the component. The purpose of the marking, or markings, is to provide a distinct boundary between high and low reflectivity surfaces which is transverse to the direction of movement of the component thereby enabling movement of the component to be readily detected. As a result it will be appreciated that the marking need not be limited to stripes and can take other forms.

Furthermore it is also envisaged that other rotating components can be used in place of the magnetic suspension arrangement. For example, an additional rotating component having one or more visually distinctive marks on its surface could be specifically incorporated in the meter or an existing component specifically adapted to include markings on its surface.

A first aspect of the present invention thus resides in the realisation of adapting an electro-mechanical electricity consumption meter to include a rotating component having at least one visually distinctive marking on its surface or to adapt an existing component to have such a marking, the markings being for the specific purpose of facilitating the attachment of electronic modules which provide a function ancillary to the basic metering function. Hitherto efforts have concentrated on making sophisticated optical pick-ups to utilise the far from ideal components already present in the meter. The present invention enables an inexpensive optical monitoring assembly to be used.

Whilst it is advantageous to have a two part terminal cover, it will be appreciated by those skilled in the art that a single terminal cover can be used which prevents access to both the supply and load terminals.

## Claims

1. An electro-mechanical electricity consumption meter (1) of a type having a sealed housing (2) to prevent tampering therewith, the sealed housing having a transparent region permitting visibility of a consumption indicator, connecting terminals (3a,3b) for connecting the meter to an electricity supply (Lᵢₙ, Nᵢₙ) and to a load (Lₒᵤₜ, Nₒᵤₜ), and a rotor assembly (6) whose rate of rotation is related to the rate of consumption of electricity, part of the rotor assembly (6) or a component (11) adapted to rotate with the rotor assembly (6) having at least one marking thereon such that the rate of rotation of the rotor assembly can be determined using an optical monitoring assembly (24), **characterised by** a removable sealable cover structure (21) disposed over a portion of the sealed housing other than the said transparent region, which structure in conjunction with the sealed housing provides a volume in which the optical monitoring assembly can be housed externally of and relative to the sealed housing (2) so as to view the part or component (11) through the sealed housing from under the cover structure.

2. An electro-mechanical electricity consumption meter according to Claim 1 wherein said part of the rotor assembly or said component is located in close proximity to said connecting terminals (3a, 3b).

3. An electro-mechanical electricity consumption meter according to Claim 1 wherein the rotating component (11) comprises a part of a magnetic suspension arrangement (10,11) of the rotor assembly (6) which is adapted to have the at least one marking (15) on a surface thereof.

4. An electro-mechanical electricity consumption meter according to any preceding claim wherein the sealable cover structure comprises at least one sealable terminal cover (21a) for preventing access to one or more of said terminals (3a, 3b).

5. An electro-mechanical electricity consumption meter according to any preceding claim wherein the cover structure (21) comprises a first cover (21a) which prevents access to supply connecting terminals (3a) and a second cover (21) providing said volume in conjunction with the sealed housing (2).

6. An electro-mechanical electricity consumption meter according to any preceding claim wherein the at least one marking (15) comprises a visually distinctive boundary between two surface areas of substantially different reflectivity.

7. An electro-mechanical electricity consumption meter according to Claim 6 wherein the areas (15, 16) comprises metallic chromium and a plastics material.

8. An electro-mechanical electricity consumption meter according to Claim 6 and comprising a clip (18) which fits over a part of the magnet suspension arrangement (11) and includes regions (19) which mask the surface of the magnetic suspension arrangement (11) to define the at least one marking (15).

9. An electro-mechanical electricity consumption meter according to Claim 8 wherein the clip (18) is made from stainless steel or nickel plated brass.

10. An electro-mechanical electricity consumption meter according to Claim 3 or any claim dependent therefrom, wherein the sealed housing (2) is adapted to include a recessed region (20) to enable the optical monitoring assembly (24) to be located in close proximity to the magnetic suspension arrangement (10, 11), said recessed region (20) further including barrier means (31) for preventing a magnet being placed in close proximity to the magnetic suspension arrangement or the rotor assembly (6).

11. An electro-mechanical electricity consumption meter according to any preceding claim comprising means (37) for directing light (38) from under said sealable cover structure (21) to the transparent region (39) of the sealed housing (2).

12. An electro-mechanical electricity consumption meter according to any preceding claim wherein the meter (1) is further adapted such that an isolating switch (32) is connectable to the connecting terminals (3a, 3b), the isolating switch (32) being located externally of the sealed housing (2) and enclosed by the sealable cover structure (21).

13. An electro-mechanical electricity consumption meter according to any of Claims 1 to 12, fitted with a module, said module being configured to provide an ancillary function to the metering of the commodity and comprising an optical monitoring assembly (24) for detecting rotation of the rotating component (11) and electrical circuitry (28) said module being adapted to be located outside the sealed housing (2) and to be enclosed by the sealable cover structure (21).

## Patentansprüche

1. Ein elektromechanischer Verbrauchsmesser (1) für Elektrizität von einer Bauart mit einem versiegelten bzw. plombierten Gehäuse (2), um zu verhindern, dass man sich daran zu schaffen macht, wobei das versiegelte bzw. plombierte Gehäuse einen transparenten Bereich besitzt, welcher die Sicht auf einen Verbrauchsindikator bzw. -anzeiger gestattet, Verbindungsanschlüsse (3a, 3b) zum Verbinden des Verbrauchsmessers mit einer elektrischen Stromversorgung (L_{in,} Nᵢₙ) und mit einer Last (Lₒᵤₜ, Nₒᵤₜ) aufweist und eine Rotoranordnung (6) aufweist, deren Drehgeschwindigkeit in Bezug zu der Verbrauchshöhe von Elektrizität bzw. elektrischem Strom ist, wobei ein Teil der Rotoranordnung (6) oder ein Bauteil (11), welches geeignet ist, sich mit der Rotoranordnung (6) zu drehen, wenigstens eine Markierung darauf dergestalt besitzt, dass die Geschwindigkeit der Drehung der Rotoranordnung durch Verwendung einer optischen Überwachungsanordnung (24) bestimmt werden kann,
**gekennzeichnet durch**
einen abnehmbaren bzw. entfernbaren versiegelbaren bzw. plombierbaren Deckelaufbau (21), welcher über einem anderen Teil des versiegelten bzw. plombierten Gehäuses als der besagte transparente Bereich angeordnet ist, welcher Aufbau in Verbindung mit dem versiegelten bzw. plombierten Gehäuse ein Volumen schafft, in welchem die optische Überwachungsanordnung außerhalb von und in Bezug auf das versiegelte bzw. plombierte Gehäuse (2) so untergebracht werden kann, dass der Teil oder das Bauteil (11) **durch** das versiegelte bzw. plombierte Gehäuse von unter dem Deckelaufbau sichtbar ist.

2. Ein elektromechanischer Verbrauchsmesser für Elektrizität gemäß Anspruch 1, wobei der besagte Teil der Rotoranordnung oder des besagten Bauteils in enger Nähe zu den Verbindungsanschlüssen (3a, 3b) angeordnet ist.

3. Ein elektromechanischer Verbrauchsmesser für Elektrizität gemäß Anspruch 1, wobei das drehende Bauteil (11) einen Teil einer magnetischen Abstützungs- bzw. Aufhängungsanordnung (10, 11) der Rotoranordnung (6) aufweist, welche geeignet bzw. eingerichtet ist, wenigstens eine Markierung (15) auf einer Oberfläche von ihr zu besitzen.

4. Ein elektromechanischer Verbrauchsmesser für Elektrizität gemäß irgendeinem vorhergehenden Anspruch, wobei der versiegelbare bzw. plombierbare Deckelaufbau wenigstens einen versiegelbaren bzw. plombierbaren Deckel (21a) für die Anschlüsse aufweist, um den Zugang zu einem oder mehreren der besagten Anschlüsse (3a, 3b) zu verhindern.

5. Ein elektromechanischer Verbrauchsmesser für Elektrizität gemäß irgend einem vorhergehenden Anspruch, wobei der Deckelaufbau (21) einen ersten Deckel (21a) aufweist, welcher den Zugang zu den Anschlüssen (3a) für die Verbindung mit der Stromversorgung verhindert und einen zweiten Deckel (21), welcher das besagte Volumen in Verbindung mit dem versiegelten bzw. plombierten Gehäuse (2) schafft.

6. Ein elektromechanischer Verbrauchsmesser für Elektrizität gemäß irgend einem vorhergehenden Anspruch, wobei die wenigstens eine Markierung (15) eine visuell unterscheidbare Begrenzung bzw. Bereichsgrenzung zwischen zwei Oberflächenbereichen von wesentlich unterschiedlichem Reflektionsvermögen aufweist.

7. Ein elektromechanischer Verbrauchsmesser für Elektrizität gemäß Anspruch 6, wobei die Bereiche (15, 16) metallisches Chrom und ein Kunststoffmaterial aufweisen.

8. Ein elektromechanischer Verbrauchsmesser für Elektrizität gemäß Anspruch 6, welcher einen Clip (18) aufweist, welcher über einen Teil der magnetischen Abstützungs- bzw. Aufhängungsanordnung (11) passt, und Bereiche (19) einschließt, welche die Oberfläche der magnetischen Abstützungs- bzw. Aufhängungsanordnung (11) maskieren, um die wenigstens eine Markierung (15) zu definieren bzw. zu begrenzen.

9. Ein elektromechanischer Verbrauchsmesser für Elektrizität gemäß Anspruch 8, wobei der Clip (18) aus rostfreiem Stahl oder mit Nickel plattiertem Messing ist.

10. Ein elektromechanischer Verbrauchsmesser für Elektrizität gemäß Anspruch 3 oder irgendeinem davon abhängigen Anspruch, wobei das versiegelte bzw. plombierte Gehäuse (2) geeignet ist, einen ausgesparten Bereich (20) zu enthalten bzw. einzuschließen, um es zu ermöglichen, dass die optische Überwachungsanordnung (24) in enger Nähe zu der magnetischen Abstützungs- bzw. Aufhängungsanordnung (10, 11) angeordnet ist, wobei der ausgesparte Bereich (20) weiter Barriereneinrichtungen (31) aufweist, um zu verhindern, dass ein Magnet in enger Nähe zu der magnetischen Abstützungs- bzw. Aufhängungsanordnung oder der Rotoranordnung (6) angeordnet wird.

11. Ein elektromechanischer Verbrauchsmesser für Elektrizität gemäß irgend einem vorhergehenden Anspruch, welcher Einrichtungen (37) aufweist, um Licht (38) von unter dem besagten versiegelbaren bzw. plombierbaren Deckelaufbau (21) zu dem transparenten Bereich (39) des versiegelten bzw. plombierten Gehäuses (2) zu richten.

12. Ein elektromechanischer Verbrauchsmesser für Elektrizität gemäß irgend einem vorhergehenden Anspruch, wobei der Verbrauchsmesser (1) weiterhin derart eingerichtet bzw. geeignet ist, dass ein isolierender Schalter bzw. Trennschalter (32) mit den Verbindungsanschlüssen (3a, 3b) verbindbar ist, wobei der isolierende Schalter bzw. Trennschalter (32) außerhalb des isolierten bzw. plombierten Gehäuses (2) angeordnet ist und durch den isolierbaren bzw. plombierbaren Deckelaufbau (21) eingeschlossen ist.

13. Ein elektromechanischer Verbrauchsmesser für Elektrizität gemäß irgend einem der Ansprüche 1 bis 12, welcher mit einem Modul ausgestattet ist, wobei der besagte Modul so ausgebildet ist, dass er eine Hilfsfunktion für die Messung des Verbrauchsgutes schafft und eine optische Überwachungsanordnung (24) zur Feststellung der Drehung des drehenden Bauteils (11) und eine elektrische Schaltung (28) aufweist, wobei der besagte Modul geeignet ist, außerhalb des versiegelten bzw. plombierten Gehäuses (2) angeordnet zu sein und durch den versiegelbaren bzw. plombierbaren Deckelaufbau (21) eingeschlossen zu sein.

## Revendications

1. Appareil électromécanique (1) de mesure de consommation d'électricité d'un type possédant un boîtier scellé (2) empêchant toute tentative de manipulation, le boîtier scellé possédant une zone transparente permettant la visibilité d'un indicateur de consommation, des bornes de connexion (3a,3b) pour connecter l'appareil de mesure à une source d'alimentation électrique (Lᵢₙ, Nᵢₙ) et à une charge (Lₒᵤₜ, Nₒᵤₜ), et un ensemble formant rotor (6), dont la vitesse de rotation est associée au taux de consommation d'électricité, une partie de l'ensemble formant rotor (6) ou un composant (11) adapté pour tourner conjointement avec l'ensemble formant rotor (6) portant au moins une marque de telle sorte que la vitesse de rotation de l'ensemble formant rotor peut être déterminée en utilisant un ensemble de contrôle optique (24), **caractérisé par** une structure de capot amovible pouvant être scellée (21), disposée au-dessus d'une partie du boîtier scellé autre que ladite région transparente, laquelle structure définit, en liaison avec le boîtier scellé, un volume, dans lequel l'ensemble de contrôle optique peut être logé à l'extérieur du boîtier scellé (2) et par rapport à ce dernier de manière que la partie ou le composant (11) soit visible à travers le boîtier scellé à partir du dessous de la structure formant capot.

2. Appareil électromécanique de mesure de consommation d'électricité selon la revendication 1, dans lequel ladite partie de l'ensemble formant rotor ou ledit composant est situé(e) à proximité directe desdites bornes de connexion (3a,3b).

3. Appareil électromécanique de mesure de consommation d'électricité selon la revendication 1, dans lequel le composant rotatif (11) comprend une partie d'un dispositif de suspension magnétique (10,11) de l'ensemble formant rotor (6), qui est adaptée pour posséder ladite au moins une marque (15) sur l'une de ses surfaces.

4. Appareil électromécanique de mesure de consommation d'électricité selon l'une quelconque des revendications précédentes, dans lequel la structure de capot pouvant être scellée comprend au moins un capot de borne (21a) pouvant être scellé pour empêcher l'accès à une ou plusieurs desdites bornes (3a,3b).

5. Appareil électromécanique de mesure de consommation d'électricité selon l'une quelconque des revendications précédentes, dans lequel la structure formant capot (21) comprend un premier capot (21a) qui empêche d'accéder à des bornes de connexion d'alimentation (3a) et un second capot (21) définissant ledit volume en liaison avec le boîtier scellé (2).

6. Appareil électromécanique de mesure de consommation d'électricité selon l'une quelconque des revendications précédentes, dans lequel la au moins une marque (15) comprend une limite, que l'on peut distinguer visuellement, entre deux zones de surface ayant des coefficients de réflexion sensiblement différents.

7. Appareil électromécanique de mesure de consommation d'électricité selon la revendication 6, dans lequel les zones (15,16) comprennent du chrome métallique et une matière plastique.

8. Appareil électromécanique de mesure de consommation d'électricité selon la revendication 6 et comprenant une pince (18) qui s'adapte sur une partie du dispositif de suspension magnétique (11) et inclut des régions (19), qui masquent la surface du dispositif de suspension magnétique (11) pour définir la au moins une marque (15).

9. Appareil électromécanique de mesure de consommation d'électricité selon la revendication 8, dans lequel la pince (18) est réalisée en acier inoxydable ou en laiton plaqué de nickel.

10. Appareil électromécanique de mesure de consommation d'électricité selon la revendication 3 ou n'importe quelle revendication dépendante de cette revendication, dans lequel le boîtier scellé (2) est adapté pour inclure une région en renfoncement (20) de manière à permettre de disposer l'ensemble de contrôle optique (24) à proximité directe du dispositif de suspension magnétique (10,11), ladite région en renfoncement (20) comprenant en outre des moyens formant barrière (31) pour empêcher qu'un aimant soit placé à proximité directe du dispositif de suspension magnétique ou de l'ensemble formant rotor (6).

11. Appareil électromécanique de mesure de consommation d'électricité selon l'une quelconque des revendications précédentes, comprenant des moyens (37) pour diriger la lumière (38) depuis le dessous de ladite structure de capot pouvant être scellée (21) jusqu'à la région transparente (39) du boîtier scellé (2).

12. Appareil électromécanique de mesure de consommation d'électricité selon l'une quelconque des revendications précédentes, dans lequel l'appareil de mesure (1) est en outre adapté de telle sorte qu'un interrupteur d'isolation (32) peut être connecté aux bornes de connexion (3a,3b), l'interrupteur d'isolation (32) étant situé à l'extérieur du boîtier scellé (2) et étant enveloppé par la structure formant capot pouvant être scellée (21).

13. Appareil électromécanique de mesure de consommation d'électricité selon l'une quelconque des revendications 1 à 12, équipé d'un module, ledit module étant configuré de manière à fournir une fonction secondaire pour la mesure de la ressource et comprenant un ensemble de contrôle optique (24) pour détecter la rotation du composant rotatif (11) et un circuit électrique (28a), ledit module étant adapté pour être situé à l'extérieur du boîtier scellé (2) et pour être enveloppé par la structure formant capot pouvant être scellée (21).
